# EUROPÄISCHE PATENTANMELDUNG

(11) **EP 0 566 929 A1**
(43) Veröffentlichungstag der Anmeldung: **27.10.1993**
(21) Anmeldenummer: 93105737.6
(22) Anmeldetag: 07.04.1993
(51) Int. Cl.: G02B 6/12, G02B 6/36, H01L 21/304, H01L 21/306

(54) **Verfahren zum Herstellen von mikromechanischen Strukturen in einkristallinem Halbleitermaterial**

(30) Priorität: 21.04.1992 DE 4213118
(71) Anmelder: ANT Nachrichtentechnik GmbH, D-71522 Backnang (DE)
(72) Erfinder: Wörner, Andreas, Dipl.-Ing. (FH), W-7153 Weissach i.T. (DE)

(57) **Zusammenfassung**

Durch eine Kombination von Maskierungstechnik und anisotropem Ätzen ist es möglich, in Silizium und anderen Halbleitermaterialien sehr genaue Nuten herzustellen. Es ist bereits bekannt, diese Nuten durch Bearbeitung mit einem Laser vor dem Ätzen zu modifizieren.

Eine weitere Erhöhung der Genauigkeit, insbesondere für langgestreckte Nuten, ist erreichbar, wenn man zur Modifikation eine Säge einsetzt. Es ist möglich, eine maskierte Scheibe aus Halbleitermaterial zunächst anisotrop zu ätzen, die geätzten Strukturen mit einer Säge zu bearbeiten und anschließend wiederum anisotrop zu ätzen. Auf den ersten Ätzvorgang kann dabei auch verzichtet werden. Es entstehen im Querschnitt rautenförmige Nuten, in denen eine Fixierung von optischen Komponenten sehr einfach ist.

## Beschreibung

Die Erfindung betrifft ein Verfahren zum Herstellen von mikromechanischen Strukturen in einkristallinem Halbleitermaterial, bei dem die hohe Genauigkeit von Maskentechnik und anisotropem Ätzen ausgenutzt wird.

Die Reproduzierbarkeit von kristallographischen Winkeln und Ebenen ist aus physikalischen Gründen sehr hoch. Diese Eigenschaften können ausgenutzt werden, um Halterungen für mikrooptische Komponenten und für Lichtwellenleiter herzustellen. Um in einkristallinen Halbleitermaterialien, z.B. Silizium, Fixierungsstrukturen unterschiedlicher Form vorzusehen, ist die alleinige Kombination der Maskentechnik mit anisotropem Ätzen nicht ausreichend. Aus R. Krahn, H. Reichl "Micro System Technologies 91" (Vote-Verlag) "New Microstructures in Silicon using Laser Machining and Anisotropic Etching" von M. Alavi, S. Büttgenbach, A. Schumacher, H.-J. Wagner, Hahn-Schickard-Gesellschaft für angewandte Forschung e.V., W-7000 Stuttgart, 199, S. 322-324, ist es bekannt, mikromechanische Strukturen in Silizium mit Hilfe eines Lasers zu modifizieren. Dazu wird die Oberfläche einer Siliziumscheibe zunächst mit Hilfe der Maskentechnik strukturiert. In einem unmaskierten Bereich der Siliziumscheibe, an einer Stelle, an der eine Nut vorgesehen ist, wird dann mit dem Laser ein Schnitt in der Siliziumscheibe erzeugt. Dadurch werden schnell- und langsam ätzende Kristallebenen freigelegt bzw. beschädigt. Bei einem auf die Laserbearbeitung folgenden anisotropen Ätzprozeß entstehen nun Nuten, die aufgrund des Einschnittes mit dem Laser von ihrer Form her modifiziert sind. So entstehen beispielsweise bei einer Siliziumscheibe, deren Oberfläche mit einer (100)-Ebene des Kristalles zusammenfällt (Bezeichnung der Ebenen mit den Millerschen Indizes), ohne Laserbehandlung V-Nuten und mit Laserbehandlung im Schnitt rautenartige Nuten.

Die Bearbeitung mit einem Laser stellt sich insofern als nachteilig heraus, als es sehr schwierig ist, eine präzise und reproduzierbare Schnittiefe und Position über einen langen Bereich zu erhalten. Variationen der Schnittiefe ergeben jedoch beim anisotropen Ätzen unterschiedliche Nutquerschnitte. Eine genaue Fixierung der optischen Bauelemente ist dann nicht mehr möglich.

In der US 4 604 161 ist ein Verfahren beschrieben, bei dem Sägeschnitte in Verbindung mit anisotropem Ätzen angewendet werden, um bei einer Siliziumscheibe definierte Bruchkanten in (111)-Richtung zu erzielen. Hier wird durch strukturiertes Maskieren mit anschließendem anisotropem Ätzen auf der aktiven Oberfläche der Siliziumscheibe eine V-Nut erzeugt. Im nächsten Schritt wird ein Sägeschnitt in die Rückseite des Wafers parallel, aber etwas versetzt zur V-Nut, ausgeführt. Durch die Einwirkung einer Kraft kann nun eine definierte Bruchstelle in (111)-Richtung zwischen der V-Nut und dem Sägeschnitt erzeugt werden.

Aus der US 4 522 682 ist weiterhin ein Verfahren bekannt, bei dem strukturierte Maskierungen, Sägeschnitte und anisotropes Ätzen angewendet werden, um freitragende Strukturen, vom Substrat dielektrisch isolierte PNP-Transistoren, zu erzeugen.

Es ist Aufgabe der Erfindung, ein Verfahren zum Herstellen von mikromechanischen Strukturen auf einkristallinen Halbleitermaterialien anzugeben, bei dem geätzte Strukturen mit geringem Aufwand und hoher Präzision modifiziert werden können.

Verfahren mit den Merkmalen der Patentansprüche 1 oder 2 lösen diese Aufgabe. Vorteilhafte Weiterbildungen sind in den Unteransprüchen angegeben.

Als Halbleitermaterialien können insbesondere Silizium, Galliumarsenid oder Indiumphosphid verwendet werden. Siliziumscheiben, oftmals als 4''-Wafer, werden beispielsweise mit Siliziumdioxyd und Siliziumnitrit maskiert. Durch die Maskenstruktur werden Geometrien und Abmessungen der zu ätzenden Nuten vorgegeben. Die Siliziumscheiben können anisotrop mit hochkonzentrierter Kalilauge geätzt werden. Die durch diese bekannte Vorgehensweise erhaltenen Nuten können nun durch Bearbeitung mit einer Präzisionssäge modifiziert werden. Dies kann sowohl vor dem Ätzen als auch nach einem ersten Ätzschritt und vor einem zweiten Ätzschritt erfolgen.

Durch die Lage und die Tiefe des Sägeschnittes wird die Geometrie der Nuten beeinflußt und definiert verändert. Da Sägeschnitte hochgenau in Silizium anbringbar sind, ist es möglich, Nuten mit konstantem Querschnitt herzustellen. Somit wird eine Fixierung von optischen Komponenten ermöglicht.

Die Anwendung des erfindungsgemäßen Verfahrens ist sowohl bei Siliziumwafern, deren Oberfläche mit einer (100)-Ebene, als auch bei Siliziumwafern, deren Oberfläche mit einer (110)-Ebene zusammenfällt, möglich.

Andere einkristalline Halbleitermaterialien können ebenfalls anisotrop geätzt und mit einer Präzissionssäge bearbeitet werden. Bei diesen läßt sich das Verfahren in der gleichen Weise anwenden.

Ausführungsbeispiele der Erfindung werden anhand der Zeichnungen für das einkristalline Halbleitermaterial Silizium beschrieben. Es zeigen:
Figuren 1 bis 4 einen Schnitt durch eine Siliziumscheibe nach den einzelnen Verfahrensschritten eines Verfahrens nach Patentanspruch 1,
Figuren 5 und 6 Schnitte durch eine Siliziumscheibe mit gegenüber den Figuren 3 und 4 veränderter Lage des Sägeschnittes,
Figur 7 Fixierung einer Lichtleitfaser in einer modifizierten Nut,
Figur 8 Fixierung eines beweglichen Schlittens aus Silizium in einer modifizierten Nut und die
Figuren 9 bis 11 Schnitte durch eine Siliziumscheibe nach den einzelnen Verfahrensschritten eines Verfahrens gemäß dem Patentanspruch 2.

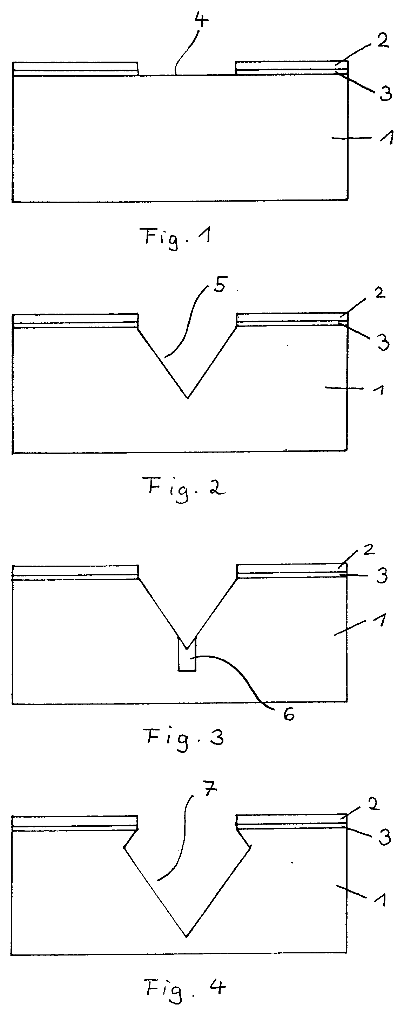

In den Figuren 1 bis 11 ist jeweils ein Querschnitt durch eine Siliziumscheibe 1, insbesondere ein 4''-Wafer aus einkristallinem Silizium, gezeigt. Die Siliziumscheibe ist mit einer Maskierung versehen, die sich zusammensetzt aus einer Siliziumoxydschicht 3, die beispielsweise 50 nm dick ist, und einer Siliziumnitritschicht, die beispielsweise 140 nm dick ist. Die Oberfläche der Siliziumscheibe 1 weist maskierte und unmaskierte Bereiche 4 auf. Wenn man eine so maskierte Siliziumscheibe 1 mit hochkonzentrierter Kalilauge anisotrop ätzt, so entstehen im unmaskierten Bereich 4 im Querschnitt V-förmige Nuten 5. Bringt man im Nutgrund einer solchen V-förmigen Nut einen Sägeschnitt 6 an, der eine bestimmte Sägeschnittstiefe aufweist, so kann man die im Querschnitt V-förmige Nut durch nochmaliges Ätzen modifizieren. Es ergibt sich eine Nut mit einem Rautenquerschnitt 7, deren Geometrie durch die Sägeschnittiefe vorbestimmt werden kann. (Figuren 1 bis 4). Sägeschnittiefe und Sägeposition müssen sehr genau eingehalten werden und sind beispielsweise mit einer Präzisionssäge einstellbar. Die verwendete Präzisionssäge muß für Siliziummaterialien geeignet sein. Beispielsweise kann ein 40 µm dickes Diamantsägeblatt verwendet werden. Wenn man die Lage des Sägeschnittes verändert, so verändert sich auch der Querschnitt der Nut.

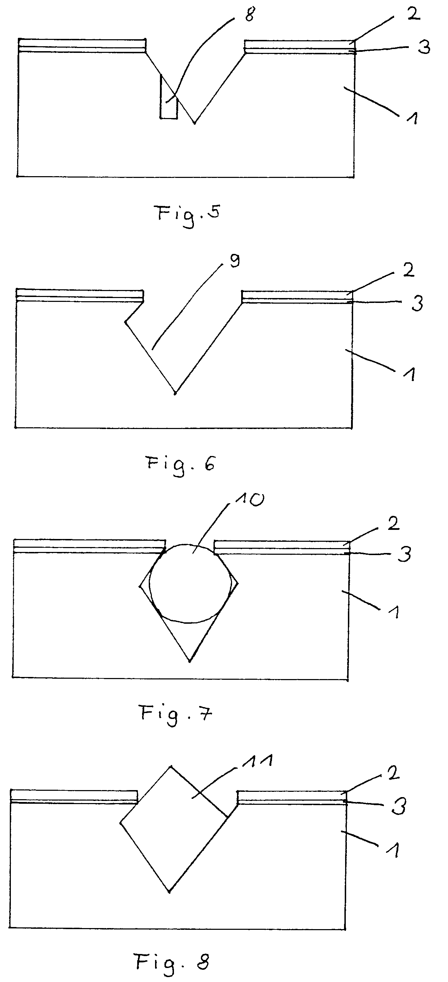

Die Figuren 5 und 6 zeigen eine geänderte Lage eines Sägeschnittes 8 und die nach anisotropem Ätzen entstandene Nut 9. Hier stimmen Sägeschnitt und Nutsymmetrieachse nicht überein. In den dargestellten Beispielen entspricht die Oberfläche der Siliziumscheibe 1 einer (100)-Ebene und die begrenzenden Flanken entsprechen den (111)-Ebenen, die unter 54,7° zur (100)-Ebene geneigt sind und sich dadurch auszeichnen, daß die Ätzrate senkrecht zu diesen Ebenen im Vergleich zur Ätzrate senkrecht zu anderen Kristallebenen sehr gering ist.

In Figur 4 ist gezeigt, wie ein Lichtwellenleiter 10, eine Faser, in der modifizierten Nut mit rautenförmigem Querschnitt fixiert werden kann. Die Nut sollte dazu einige Zentimeter lang ausgebildet sein. Die Fixierungseigenschaften einer solchen Nutform sind gegenüber der aus Figur 2 um den Wegfall eines Freiheitsgrades in vertikaler Richtung zur Faserlängsachse verbessert. Es ist dabei notwendig, daß der Nutquerschnitt sich über den gesamten Bereich nicht ändert.

Figur 8 zeigt einen beweglichen Schlitten aus Silizium 11, auf dem beispielsweise ein aktives optisches Bauelement montiert wird, der in eine Nut beweglich eingesetzt ist. Eine solche Anordnung kann beispielsweise als optischer Schalter in einem elektrooptischen Modul dienen.

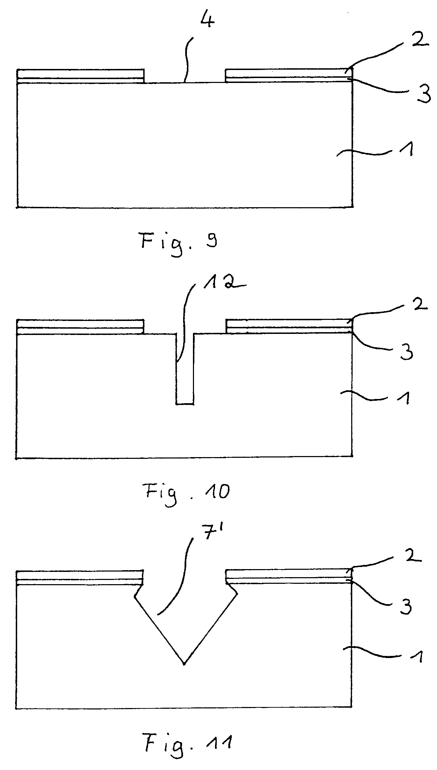

In den Figuren 9 bis 11 wird davon ausgegangen, daß die maskierte Siliziumscheibe im ersten Bearbeitungsschritt nicht geätzt wird, sondern zunächst mit einem Sägeschnitt 12 versehen wird. Der Sägeschnitt wird in einem unmaskierten Bereich 4 der Oberfläche der Siliziumscheibe 1 angebracht. Durch anisotropes Ätzen entsteht eine Nut 7', die dann rautenförmig ausgebildet ist, wenn der Sägeschnitt 12 eine entsprechende Sägeschnittiefe aufweist.

## Patentansprüche

1. Verfahren zum Herstellen von mikromechanischen Strukturen in einkristallinem Halbleitermaterial, wobei
a) die Oberfläche einer Scheibe aus Halbleitermaterial (1) mit Maskierungen (2,3) versehen wird,
b) die unmaskierten Bereiche (4) der Scheibe aus Halbleitermaterial (1) anisotrop geätzt werden,
c) die geätzten Strukturen (5) mit Sägeschnitten versehen werden
d) und anschließend die mit Sägeschnitten versehenen geätzten Strukturen nochmals anisotrop geätzt werden.

2. Verfahren zum Herstellen von mikromechanischen Strukturen in einkristallinem Halbleitermaterial, wobei
a) die Oberfläche einer Scheibe aus Halbleitermaterial (1) mit Maskierungen (2,3) versehen wird,
b) die Oberfläche der Scheibe aus Halbleitermaterial (1) an unmaskierten Bereichen (4) mit Sägeschnitten versehen wird
c) und anschließend die unmaskierten, mit Sägeschnitten versehenen Bereiche (4) der Scheibe aus Halbleitermaterial (1) anisotrop geätzt werden.

3. Verfahren nach Anspruch 1 oder 2, dadurch gekennzeichnet, daß das Halbleitermaterial einkristallines Silizium ist.

4. Verfahren nach Anspruch 1, dadurch gekennzeichnet, daß die Sägeschnitte derart angebracht werden, daß die Lagen der Symmetrieachse der Sägeschnitte (6) und der geätzten Strukturen (5) übereinstimmen.

5. Verfahren nach Anspruch 1, dadurch gekennzeichnet, daß die Sägeschnitte derart angebracht werden, daß die Lagen der Symmetrieachse der Sägeschnitte (6) und der geätzten Strukturen (5) nicht übereinstimmen.
